# EUROPEAN PATENT APPLICATION

(11) **EP 0 991 185 A2**
(43) Date of publication of application: **05.04.2000**
(21) Application number: 99119261.8
(22) Date of filing: 28.09.1999
(51) Int. Cl.: H03H 9/05

(54) **Surface elastic wave device having bumps in a definite area on the device and method for manufacturing the same**

(30) Priority: 29.09.1998 JP 27606998
(71) Applicant: NEC CORPORATION, Tokyo (JP)
(72) Inventor: Ishikawa, Mitsuru, Minato-ku, Tokyo (JP); Mizuno, Yoshinori, Minato-ku, Tokyo (JP); Tanioka, Michinobu, Minato-ku, Tokyo (JP); Ootake, Kenichi, Minato-ku, Tokyo (JP)
(74) Representative: VOSSIUS & PARTNER

(57) **Abstract**

A surface elastic wave device is provided in which an influence of the stress based on a difference of the coefficients of thermal expansion between the surface elastic wave chip and a wiring substrate is reduced and a connection defective due to heat is prevented. When quartz is used for a surface elastic wave substrate (K1) and aluminum is used for the wiring substrate (52), the surface elastic wave device is characterized in that bumps are arranged within a definite area (B1) in aluminum pads (input electrode pad (4), output electrode pad (5), and ground electrode pads (G1 to G8)) placed on a functional surface of the surface elastic wave chip (1). According to the present invention, an area in which the bumps are formed, a film thickness of an aluminum pad (Al film thickness), the chip size of the surface elastic wave chip (1), and the number of the bumps are defined to a surface elastic wave substrate of quartz or LiTaO₃.

## Description

The present invention relates generally to a surface elastic wave device in which a surface elastic wave chip is flip chip joined to a wiring substrate though bumps such as solder and, more particularly, to a surface elastic wave device characterized by locating bumps in a definite area on the surface elastic wave chip.

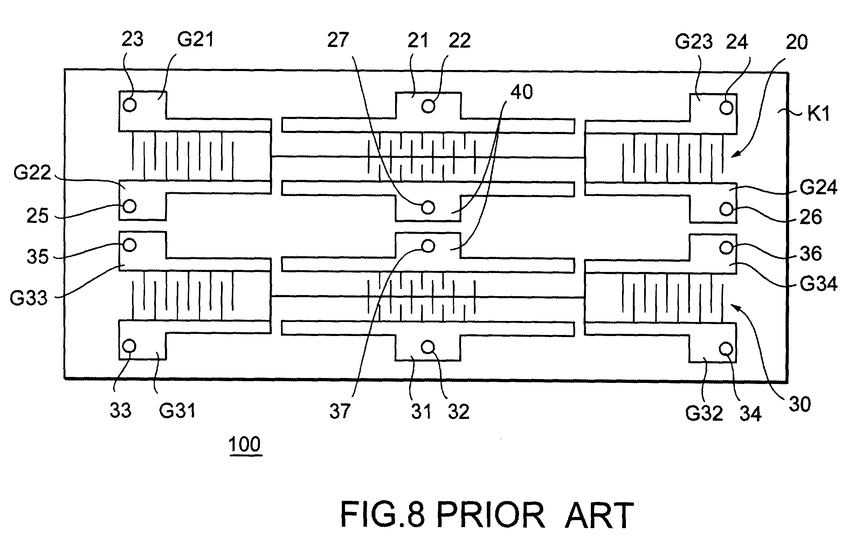

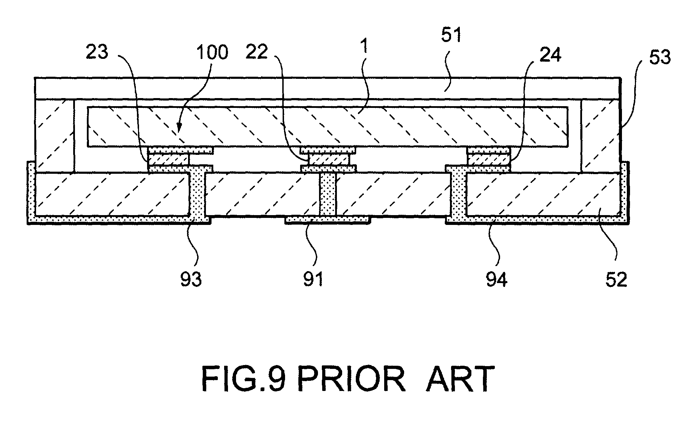

A conventional surface elastic wave chip and a surface elastic wave device formed by mounting the chip on a wiring substrate will now be described in conjunction with the drawings. FIG. 8 is a plan view showing a conventional surface elastic wave chip and FIG. 9 is a cross-sectional view showing a surface elastic wave device in which the conventional surface elastic wave chip is mounted on a wiring substrate.

In FIG. 8, a surface elastic wave chip 100 is composed of a surface elastic wave substrate K1 such as quartz and interdigital transducer electrodes (referred to as IDTs) 20, 30 formed on its substrate K1. The IDTs 20, 30 have a comb-shaped electrode structure, respectively, and are connected in series at a connecting electrode portion 40. Further, the IDT 20 has an input electrode pad 21 and ground electrode pads G21, G22, G23, and G24, and the IDT 30 has an output electrode pad 31 and ground electrode pads G31, G32, G33, and G34. Soldering bumps 22 to 27 and 32 to 37 are formed in the input electrode pad 21, the output electrode pad 31, and each ground electrode pad, respectively.

A surface elastic wave device shown in FIG. 9 was obtained such that, after a pad side of a surface elastic wave chip 100 was made to face a mounting surface of a wiring substrate 52 and bumps 22, 23, and 24 of the surface elastic wave chip 100 were electrically and mechanically connected to electrode pads 91, 93, and 94 on the wiring substrate 52, a lid 51 was sealed with solder or attached by seam weld on a frame 53. Incidentally, other bumps of the surface elastic wave chip 100 are also connected to other electrode pads on the wiring substrate.

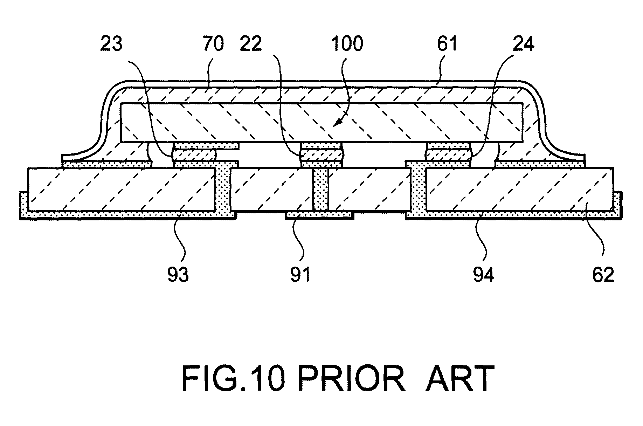

FIG. 10 shows a surface elastic wave device indicated in Japanese Patent Laid-Open No. Hei 7-111438, in which a functional surface of the surface elastic wave chip 100 and a mounting surface of a wiring substrate 62 are opposed, as shown in FIG. 9.

In order to form a space between comb-shaped electrodes formed on the functional surface of the surface elastic wave chip 100 and the mounting surface of the wiring substrate 62, pads of the both are electrically connected with each other through bumps 22, 23, and 24 (as with the other bumps in FIG. 8). The surface elastic wave device has a mounting structure such that, in order to shield the space from outside, the outer circumference of the surface elastic wave chip 100 is covered with an adhesive 70 including metal particles and its outside is encased by a solder material 61.

In the case of the surface elastic wave chip of FIG. 8, the area in which the bumps 22 to 27 and 32 to 37 are placed is outspread over a wide range on the surface elastic wave substrate, so that each bump is formed separately with each other. Specifically, the bumps 22, 27, 32, and 37 which are near to the center of the surface elastic wave chip and the bumps 23, 24, 25, 26, 33, 34, 35, and 36 which are located at the ends of the surface elastic wave chip and are considerably distant from its center are formed.

In this case, when the surface elastic wave chip is mounted as shown in FIG. 9, there is a problem such that the stress is produced at the bumps of connecting portions based on the difference of the coefficients of thermal expansion between the surface elastic wave chip 100 and the wiring substrate 52, which is occurred from the thermal stress and the temperature cycle test resulting from mounting the lid 51 after the surface elastic wave chip 100 and the opposing wiring substrate 52 has been joined. Further, the problem of the thermal stress is occurred during a temperature cycle test. Due to the thermal stress, a connection defective is occurred from the bumps located at the ends of the chip distant from the center. This is because, in the case of FIG. 9, the stress to the bumps based on the difference of the coefficients of thermal expansion between the surface elastic wave chip 100 and the wiring substrate 52 becomes larger as it is apart from the center of the surface elastic wave substrate, so that the connection defective is apt to occur at the bumps 23, 24, 25, 26, 33, 34, 35, and 36 located at the ends of the surface elastic wave chip distant from the center.

On the other hand, in the case of the surface elastic wave chip in FIG. 10, there were problems which was similar to that in FIG. 9 and which provided inferior moisture resistance property when compared with the conventional airtight sealing because the functional surface of the surface elastic wave chip 100 is protected with the adhesive 70 including metal particles and also which increased the cost due to the increase of the processes. In addition, it was difficult to control the inpouring range of the adhesive with metal particles for the purpose of formation of the space between comb-shaped electrodes and the mounting surface of the wiring substrate.

Therefore, the mounting structure of FIG. 10 is not desirable.

It is an object of the present invention to reduce the influence of the stress based on the difference of the coefficients of thermal expansion between a surface elastic wave chip and a wiring substrate and provide a surface elastic wave device and a method for manufacturing the same which does not produce a connection defective due to heat.

The surface elastic wave device according to the present invention is characterized in that, in a surface elastic wave device having a structure in which a surface elastic wave chip is connected to a wiring substrate through bumps, a quartz is used for a surface elastic wave substrate of the surface elastic wave chip, and the bumps are placed within an area of maximum 3.0 mm x 3.0 mm from a chip center in an aluminum pad placed on a functional surface of the surface elastic wave chip.

Particularly, in this case, it is desirable to arrange 16 bumps or more within an area of 1.0-3.0 mm x 1.0-3.0 mm from the chip center on a surface elastic wave chip with a chip size of 4-6 mm x 2-4 mm on an aluminum pad with a film thickness of more than 6000 angstroms on a functional surface of the surface elastic wave chip.

In addition, it is desirable to arrange four or more bumps within an area of 0-1.0 mm x 0-1.0 mm on a surface elastic wave chip with a chip size of at least 1-2 mm on an aluminum pad with a film thickness of more than 6000 angstroms on a functional surface of the surface elastic wave chip.

Further, the surface elastic wave device according to the present invention is characterized in that, in a surface elastic wave device having a structure in which a surface elastic wave chip is bonded to a wiring substrate through bumps, LiTaO₃ is used for a surface elastic wave substrate of the surface elastic wave chip, and the bumps are arranged within an area of maximum 2.5 mm x 2.5 mm from the chip center on an aluminum pad placed on a functional surface of the surface elastic wave chip.

Particularly, in this case, it is desirable to arrange 16 or more bumps within an area of 1.0-2.5 mm x 1.0-2.5 mm from the chip center on a surface elastic wave chip with a chip size of 2-4 mm x 2-4 mm on an aluminum pad with a film thickness of more than 3000 angstroms on a functional surface of the surface elastic wave chip.

In addition, it is desirable to arrange four or more bumps within an area of 0-1.0 mm x 0-1.0 mm in a surface elastic wave chip having a chip size with one side of at least 1-2 mm on an aluminum pad with a film thickness of more than 3000 angstroms on a functional surface of the surface elastic wave chip.

In the present invention, a surface elastic wave device can eliminate the reflection from a temperature stress generated by reflowing for soldering the bumps and the temperature cycle change due to the environmental change. This is because the bumps are formed by defining the area, the film thickness of the aluminum pad, and the number of the bumps corresponding to a chip size of the surface elastic wave chip.

Additionally, in a method for manufacturing the surface elastic wave device, a surface elastic wave chip is bonded to a wiring substrate through the bumps, while the wiring substrate is heated at a higher temperature than that of the surface elastic wave chip. This takes into account the coefficients of thermal expansion of the surface elastic wave chip and the wiring substrate, and contributes to the reduction of the residual stress when the temperature lowers to a room temperature.
FIG. 1 is a plan view showing a surface elastic wave chip in accordance with one embodiment of the present invention;
FIG. 2 is a cross-sectional view of a surface elastic wave device in which the surface elastic wave chip of FIG. 1 is mounted;
FIGS. 3A to 3E are cross-sectional view to help explain a method for manufacturing the surface elastic wave device of FIG. 2;
FIG. 4 is a plan view showing a surface elastic wave device in an experimental example in accordance with the embodiment of the present invention;
FIG. 5 is a plan view showing a surface elastic wave device in another experimental example in accordance with the embodiment of the present invention;
FIG. 6 is a table to explain the surface elastic wave chip in accordance with the embodiment of the present invention;
FIG. 7 is a table to explain the experimental and comparative examples of the surface elastic wave chip in accordance with the embodiment of the present invention;
FIG. 8 is a plan view showing a conventional surface elastic wave chip;
FIG. 9 is a cross-sectional view of a conventional surface elastic wave device;
FIG. 10 a cross-sectional view of another conventional surface elastic wave device.

Next, the embodiments of the present invention will be described in detail in conjunction with the accompanying drawings.

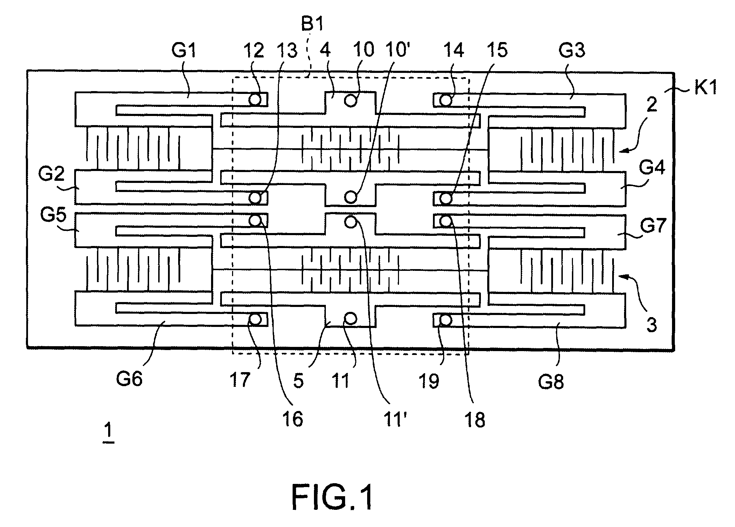

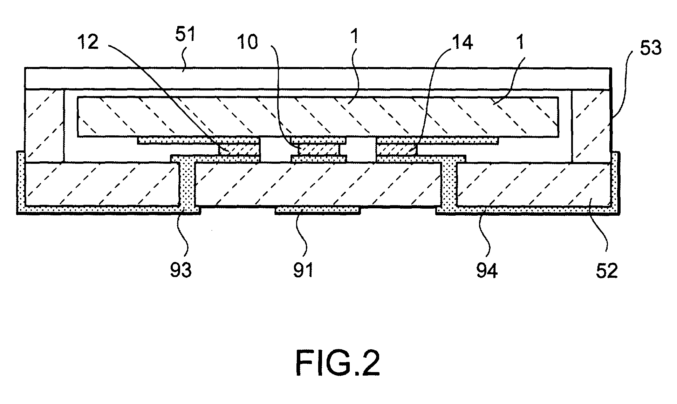

FIG. 1 is a plan view showing an embodiment of the surface elastic wave chip according to the present invention, and FIG. 2 is a cross-sectional view of a surface elastic wave device in which the surface elastic wave chip shown in FIG. 1 is mounted on a wiring substrate. In FIG. 1, the surface elastic wave chip 1 is composed of a surface elastic wave substrate K1 such as quartz and interdigital transducer electrodes (referred to as IDTs) 2, 3 formed on the substrate K1. The IDTs 2, 3 have a comb-shaped electrode structure, respectively. Further, the IDT 2 has an input electrode pad 4 and ground electrode pads G1, G2, G3, and G4, and the IDT 3 has an output electrode pad 5 and ground electrode pads G5, G6, G7, and G8. Each electrode pad is an aluminum pad. Bumps 10, 10', 11, 11', 12 to 19 (Au, Au/Pd, Cu, solder, etc.) are formed in the input electrode pad 4, the output electrode pad 5, and each of ground electrode pads, respectively.

The difference between the surface elastic wave chip 1 of FIG. 1 and the conventional surface elastic wave chip 100 of FIG. 8 is such that the ground electrode pads G1 to G8 of FIG. 1 are formed from the end of the surface elastic wave chip toward the center of the chip, and the bumps 12 to 19 on each ground electrode pad are formed at the tip portion of the pad toward its center. That is, the bumps 10 to 19 are arranged inside of an area B1 (denoted by a broken line) around a chip center of the surface elastic wave chip 1.

A surface elastic wave device of FIG. 2 was obtained such that, after a pad side of a surface elastic wave chip 1 was made to face a mounting surface of a wiring substrate 52 and bumps 10, 12, and 14 of the surface elastic wave chip 1 were electrically and mechanically connected to electrode pads 91, 93, and 94 on the wiring substrate 52, a lid 51 was sealed with solder or attached by seam weld on a frame 53. Incidentally, other bumps of the surface elastic wave chip 1 are also connected to other electrode pads on the wiring substrate.

In FIGs. 1 and 2, the embodiment of the present invention is characterized in that, when quartz is used for the surface elastic wave substrate K1 and aluminum is used for the wiring substrate 52, the bumps are arranged within a definite area B1 in the aluminum pads (the input electrode pad 4, the output electrode pad 5, and the ground electrode pads G1 to G8) placed on a functional surface of the surface elastic wave chip 1. In the case of the surface elastic wave chip 1 of FIG. 1, although the number of the bumps in the area B1 is 12, this is only one example.

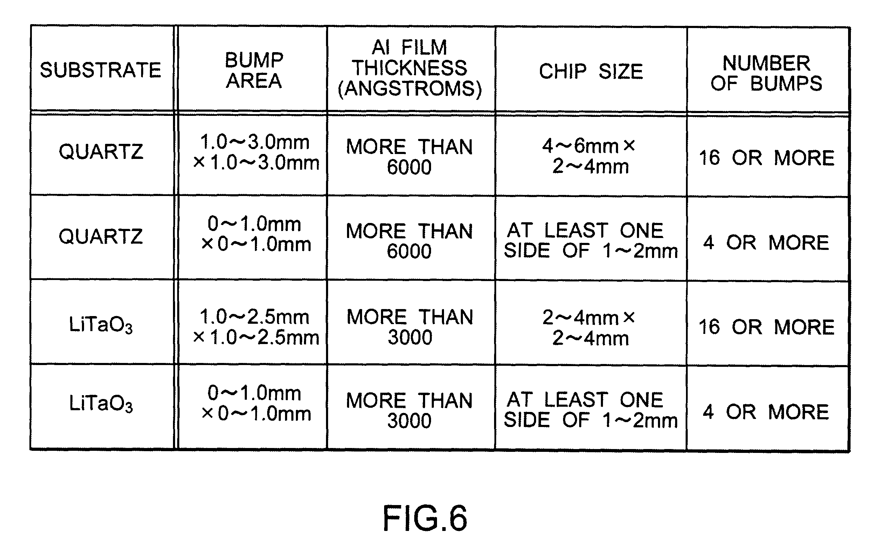

In order to reduce the influence of the stress based on the difference of the coefficients of thermal expansion between a surface elastic wave chip and a wiring substrate and obtain a surface elastic wave device which does not produce a connection defective due to heat, as a desirable embodiment according to the present invention, the area in which bumps were formed (the area B1 in FIG. 1), the film thickness of the aluminum pads (Al film thickness), the chip size of the surface elastic wave chip 1, and the number of the bumps to each surface elastic wave substrate were defined as shown in FIG. 6. In the case of the embodiment of the present invention, the relationship of FIG. 6 does not affect the pattern of the IDT electrodes 2, 3 on the surface elastic wave chip.

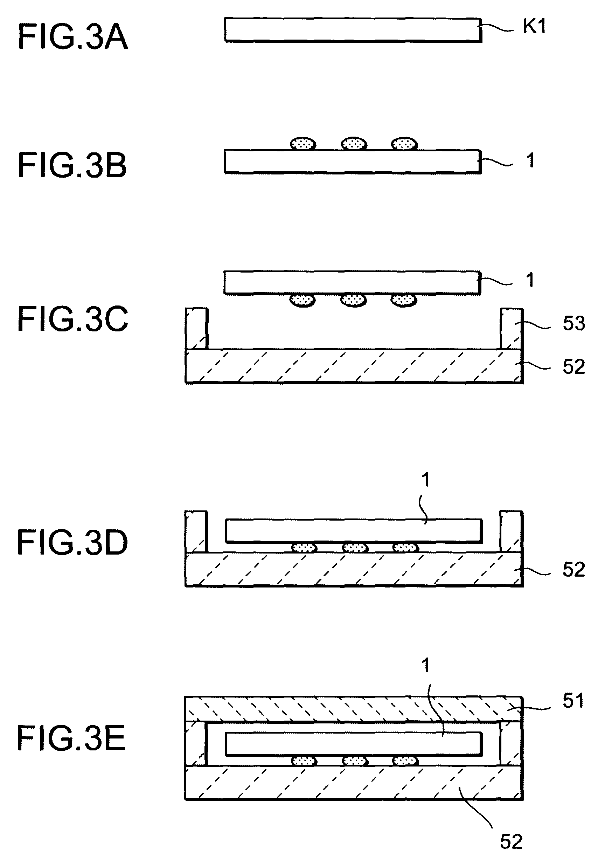

Hereinafter, FIG. 6 will be further described with reference to FIGs. 2 and 3.

The surface elastic wave device of FIG. 2 is characterized in that, when quartz is used for the surface elastic wave substrate K1 (FIG. 1) and aluminum is used for the wiring substrate 52, the bumps (the bumps 10 to 19 in FIG. 1) are arranged within the area (the area B1 in FIG. 1) of maximum 3.0 mm x 3.0 mm from the chip center in the aluminum pads (the input electrode pad 4, the output electrode pad 5, and the ground electrode pads G1 to G8) placed on the functional surface of the surface elastic wave chip 1. The chip size of the surface elastic wave chip is generally less than 6 mm x 4 mm, so that the chip size of 3.0 mm x 3.0 mm indicates the maximum area in which the bumps are arranged in that case.

In the embodiment of the present invention, a plurality of bumps may be formed on one electrode pad.

This will be further, specifically described in the relation of the area in which the bumps are formed, the film thickness of the aluminum pads (Al film thickness), the chip size of the surface elastic wave chip 1, and the number of the bumps. In the first embodiment according to the present invention, quartz is used for the surface elastic wave substrate K1 and aluminum is used for the wiring substrate 52, and the surface elastic wave chip 1 with a chip size of 4-6 mm x 2-4 mm is used. In this case, 16 or more bumps are arranged within an area of 1.0-3.0 mm x 1.0-3.0 mm (a square or rectangular area) from the center of the surface elastic wave chip on an aluminum pad with a film thickness of more than 6000 angstroms on the functional surface of the surface elastic wave chip.

In the second embodiment according to the present invention, when quartz is used for the surface elastic wave substrate K1 and aluminum is used for the wiring substrate 52, and the surface elastic wave chip 1 having a chip size with one side of at least 1-2 mm is used, four or more bumps are arranged within an area of 0-1.0 mm x 0-1.0 mm on an aluminum pad with a film thickness of more than 6000 angstroms positioned on the functional surface of the surface elastic wave device.

On the other hand, when LiTaO₃ (Lithium Thallium Oxide) is used for the surface elastic wave substrate K1 and aluminum is used for the wiring substrate 52, the bumps are arranged within an area of 2.5 mm x 2.5 mm from the chip center on an aluminum pad positioned on the functional surface of the surface elastic wave chip.

Specifically, in the third embodiment according to the present invention, when LiTaO₃ is used for the surface elastic wave substrate K1 and aluminum is used for the wiring substrate 52 and the surface elastic wave chip 1 with a chip size of 2-4 mm x 2-4 mm is used, 16 or more bumps are arranged within an area of 1.0-2.5 mm x 1.0-2.5 mm from the chip center on an aluminum pad with a film thickness of more than 3000 angstroms positioned on the functional surface of the surface elastic wave chip.

In the fourth embodiment according to the present invention, when LiTaO₃ is used for the surface elastic wave substrate K1 and aluminum is used for the wiring substrate 52 and the surface elastic wave chip 1 having a chip size with one side of at least 1-2 mm is used, four or more bumps are arranged within an area of 0-1.0 mm x 0-1.0 mm on an aluminum pad with a film thickness of more than 3000 angstroms positioned on the functional surface of the surface elastic wave chip.

According to the above-mentioned embodiments, the influence of the stress based on the difference of the coefficients of thermal expansion between the surface elastic wave chip and the wiring substrate can be reduced and the surface elastic wave device which does not produce a connection defective due to heat can be obtained. Incidentally, glass-ceramic can be used for the wiring substrate as well instead of aluminum.

Next, a preferable method for manufacturing the surface elastic wave device in FIG. 2 will be described with reference to FIG. 3.

Firstly, bumps (Au, Au/Pd, Cu, solder, etc.) 10 to 19 are formed in aluminum pads constituted within a definite range (the area B1 in FIG. 1) in the surface elastic wave substrate K1 (FIG. 3A) (FIG. 3B).

When a quartz with a chip size of 4-6 mm x 2-4 mm is used for the surface elastic wave substrate K1, the bumps are formed within the area B1 of maximum 3.0 mm x 3.0 mm from the chip center. Next, a functional surface including the pads and a mounting surface of the wiring substrate 52 (aluminum or glass-ceramic) are made to face to bond the pads of the wiring substrate 52 and the bumps 10 to 19 (FIG. 3C).

During bonding, while the surface elastic wave chip 1 is heated to a temperature of 200 degrees C to 250 degrees C and the wiring substrate 52 is heated to a temperature of 350 degrees C to 500 degrees C, higher than that of the former, they are pressurized and held for a given period of time.

Further, there is a method such that, in order to improve the reliability, the wiring substrate 52 is held below 200 degrees C and the surface elastic wave chip 1 is held at a room temperature (20 to 25 degrees C), and they are pressurized, while the ultrasound wave is applied to them.

In either case, the setting of the heating temperature takes the coefficients of thermal expansion of the surface elastic wave chip and the wiring substrate into consideration, and contributes to the reduction of the residual stress when the temperature lowers to the room temperature.

Then, in order to prevent the corrosion of the IDT electrodes 2, 3 including a lot of aluminum, the airtight sealing is performed by seam weld or soldering seal of the lid 51.

On the other hand, in FIG. 3B, when LiTaO₃ with a chip size of 2-4 mm x 2-4 mm is used for the surface elastic wave substrate K1, the bumps are formed within an area of maximum 2.5 mm x 2.5 mm from the chip center. In addition, during bonding as shown in FIG. 3C, while the surface elastic wave chip 1 is heated to a temperature of 200 degrees C to 250 degrees C and the wiring substrate 52 is heated to a temperature of 350 degrees C to 500 degrees C, higher than that of the former, they are pressurized.

Then, in order to prevent the corrosion of the IDT electrodes 2, 3 including a lot of aluminum, the airtight sealing is performed by seam weld or soldering seal of the lid 51.

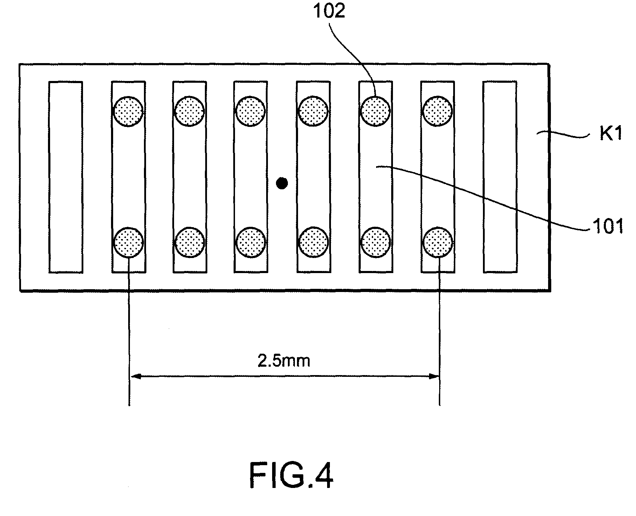

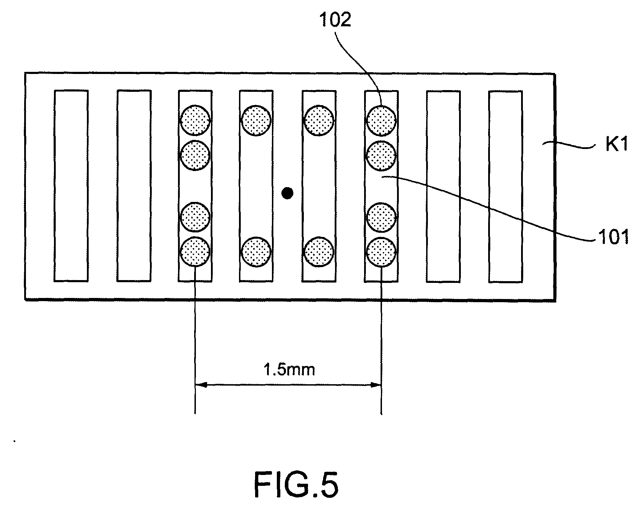

Next, experimental examples and comparative examples will be described using FIGs. 4, 5, and 7. In FIGs. 4 and 5, the surface elastic wave substrate K1 made of quartz with high coefficient of thermal expansion is used, and a plurality of bumps 102 of solder or Pb are formed on pseudo aluminum pads 101. The position of the bumps 102 are simulated to the actual bumps 10 to 19 of the surface elastic wave chip 1 shown in FIG. 1. The formation ranges of the bumps are different between FIGs. 4 and 5. The experimental surface elastic wave chips shown in FIGs. 4 and 5 were flip chip mounted on the wiring substrate 52 as shown in FIG. 2. Thereafter, reliability testing will be executed.

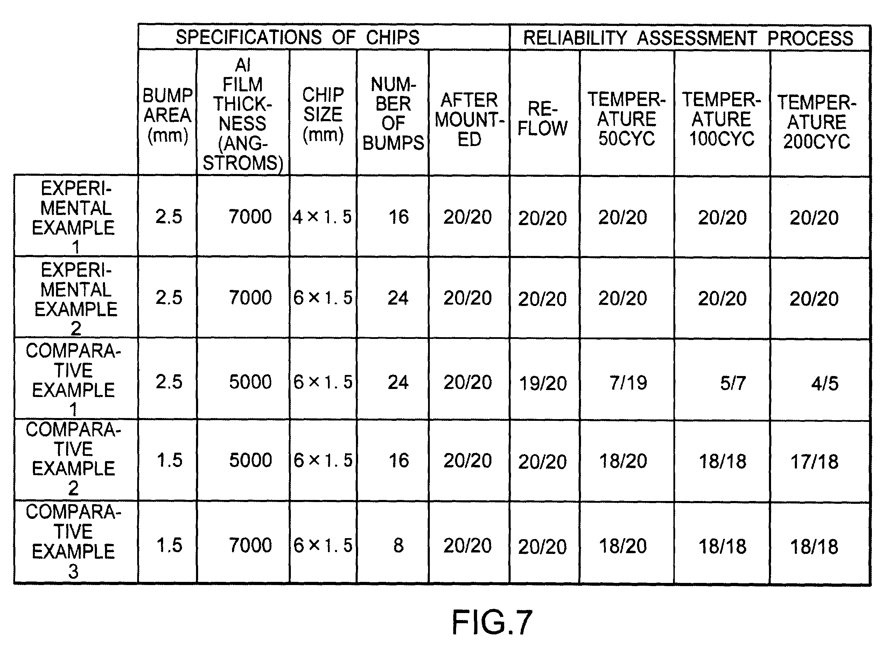

FIG. 7 is the result of confirmation of the junction condition for every process. In the reliability assessment processes, a reflow test at 250 degrees C and a temperature cycle test which repeated one cycle for 50, 100, and 200 times were executed. The cycle is defined such that, after a temperature is lowered down from a room temperature to -55 degrees C and then it is risen up to 85 degrees C, it is returned back to the room temperature. The result is expressed by normal number/assessment sample number.
(Experimental example 1) As a result of forming 16 bumps in an aluminum pad with a chip size of 4 mm x 1.5 mm, a film thickness of 7000 angstroms, and a bump area of 2.5 mm x 2.5 mm, no junction failure occurred in the reflow test and the temperature cycle test. That is, the reliability can be secured by forming the bumps in an area in which the thermal stress applied to a junction is less affected in the processes after the mount process.
(Experimental example 2) As a result of forming 24 bumps in an aluminum pad with a chip size of 6 mm x 1.5 mm, a film thickness of 7000 angstroms, and a bump area of 2.5 mm x 2.5 mm, no junction failure occurred in the reflow test and the temperature cycle test.
(Comparative example 1) As a result of forming 24 bumps in an aluminum pad with a chip size of 6 mm x 1.5 mm, a film thickness of 5000 angstroms, and a bump area of 2.5 mm x 2.5 mm, some junction failures occurred in the reflow test and the temperature cycle test. The failures occurred because the film thickness of the aluminum pad was thinner than 6000 angstroms.
(Comparative example 2) As a result of forming 16 bumps in an aluminum pad with a chip size of 6 mm x 1.5 mm, a film thickness of 5000 angstroms, and a bump area of 1.5 mm x 1.5 mm, smaller than that of comparative example 1, some junction failures occurred in the temperature cycle test. The failures occurred because the film thickness of the aluminum pad was thinner than 6000 angstroms.
(Comparative example 3) As a result of forming 8 bumps in an aluminum pad with a chip size of 6 mm x 1.5 mm, a film thickness of 7000 angstroms, and a bump area of 1.5 mm x 1.5 mm, smaller than that of comparative example 1, some junction failures occurred in the temperature cycle test. The failures occurred because the number of the bumps was smaller than 16.

When a bump area is 1.0-3.0 mm x 1.0-3.0 mm, if the number of the bumps is smaller than 16, the junction failure may occur in either assessment.

The above description related to a surface elastic wave substrate made of quartz, however, in the case of LiTaO₃, junction failures were confirmed in a bump number, a film thickness, and a bump area other than the third and fourth embodiment of the present invention.

In this way, the embodiments of the present invention can prevent the junction failure of the bumps due to the temperature change and the thermal stress by totally influencing not only the bump area but also the film thickness of the aluminum pad and the number of the bumps.

As explained above, according to the present invention, by defining an area in which bumps are formed to a chip size of a surface elastic wave substrate, an influence of the stress based on the difference of the coefficients of thermal expansion between the surface elastic wave chip and the wiring substrate can be reduced and also the surface elastic wave device and the method for manufacturing the same which do not produce a connection defective due to heat can be obtained.

According to the present invention, by defining an area in which bumps are formed, a film thickness of an aluminum pad (Al film thickness), the chip size of the surface elastic wave chip 1, and the number of the bumps to a surface elastic wave substrate of quartz or LiTaO₃, an influence of the stress based on the difference of the coefficients of thermal expansion between the surface elastic wave chip and the wiring substrate can be reduced and also the surface elastic wave device and the method for manufacturing the same which do not produce a connection defective due to heat can be obtained.

## Claims

1. A surface elastic wave device having a structure in which a surface elastic wave chip is connected to a wiring substrate through bumps, the surface elastic wave device is characterized in that,
said surface elastic wave chip has a quartz surface elastic wave substrate, a elastic wave generating electrode placed on said quartz surface elastic wave substrate, and aluminum pads connected to said elastic wave generating electrode, and the bumps are placed on said aluminum pads within an area of maximum 3.0 mm x 3.0 mm from a chip center of said surface elastic wave chip.

2. The surface elastic wave device according to claim 1, characterized in that, 16 or more bumps are arranged within an area of 1.0-3.0 mm x 1.0-3.0 mm from the chip center in said surface elastic wave chip having a chip size of 4-6 mm x 2-4 mm on said aluminum pads with a thickness of more than 6000 angstroms.

3. The surface elastic wave device according to claim 1, characterized in that, four or more bumps are arranged within an area of 0-1.0 mm x 0-1.0 mm in said surface elastic wave chip having a chip size with one side of at least 1-2 mm on said aluminum pads with a thickness of more than 6000 angstroms.

4. A surface elastic wave device having a structure in which a surface elastic wave chip is connected to a wiring substrate through bumps, the surface elastic wave device is characterized in that,
said surface elastic wave chip has a LiTaO₃ surface elastic wave substrate, a elastic wave generating electrode placed on said LiTaO₃ surface elastic wave substrate, and aluminum pads connected to said elastic wave generating electrode, and the bumps are placed on said aluminum pads within an area of maximum 2.5 mm x 2.5 mm from a chip center of said surface elastic wave chip.

5. The surface elastic wave device according to claim 4, characterized in that, 16 or more bumps are arranged within an area of 1.0-2.5 mm x 1.0-2.5 mm from the chip center in said surface elastic wave chip having a chip size of 2-4 mm x 2-4 mm on said aluminum pads with a thickness of more than 3000 angstroms.

6. The device according to claim 4 or 5, characterized in that, four or more bumps are arranged within an area of 0-1.0 mm x 0-1.0 mm in said surface elastic wave chip having a chip size with one side of at least 1-2 mm on said aluminum pads with a thickness of more than 3000 angstroms.

7. The device according to any one of claims 1 to 6, characterized in that said elastic wave generating electrode is an interdigital transducer electrode, and said aluminum pads are connected to said interdigital transducer electrode and positioned in the direction of the chip center.

8. The device according to any one of claims 1 to 7, characterized in that said bumps includes a plurality of bumps which are placed on one pad of said aluminum pads.

9. A method for manufacturing a surface elastic wave device having a structure in which a surface elastic wave chip having a quartz surface elastic wave substrate and aluminum pads placed on said quartz surface elastic wave substrate is connected to a wiring substrate through bumps, comprising the steps of,
arranging 16 or more bumps within an area of 1.0-3.0 mm x 1.0-3.0 mm from a chip center in said surface elastic wave chip with a chip size of 4-6 mm x 2-4 mm on said aluminum pads with a thickness of more than 6000 angstroms on a functional surface of said quartz surface elastic wave substrate and,
heating said wiring substrate at a higher temperature than that of said surface elastic wave chip, to bond said surface elastic wave chip to said wiring substrate through said bumps.

10. A method for manufacturing a surface elastic wave device having a structure in which a surface elastic wave chip having a quartz surface elastic wave substrate and aluminum pads placed on said quartz surface elastic wave substrate is connected to a wiring substrate through bumps, comprising the steps of,
arranging 16 or more bumps within an area of 1.0-3.0 mm x 1.0-3.0 mm from a chip center in said surface elastic wave chip having a chip size with one side of at least 1-2 mm on said aluminum pads with a thickness of more than 6000 angstroms on a functional surface of said quartz surface elastic wave substrate and,
heating said wiring substrate at a higher temperature than that of said surface elastic wave chip, to bond said surface elastic wave chip to said wiring substrate through said bumps.

11. A method for manufacturing a surface elastic wave device having a structure in which a surface elastic wave chip having a LiTaO₃ surface elastic wave substrate and aluminum pads placed on said LiTaO₃ surface elastic wave substrate is connected to a wiring substrate through bumps, comprising the steps of,
arranging 16 or more bumps within an area of 1.0-2.5 mm x 1.0-2.5 mm from a chip center in said surface elastic wave chip with a chip size of 2-4 mm x 2-4 mm on said aluminum pads with a thickness of more than 3000 angstroms on a functional surface of said LiTaO₃ surface elastic wave substrate and,
heating said wiring substrate at a higher temperature than that of said surface elastic wave chip, to bond said surface elastic wave chip to said wiring substrate through said bumps.

12. A method for manufacturing a surface elastic wave device having a structure in which a surface elastic wave chip having a LiTaO₃ surface elastic wave substrate and aluminum pads placed on said LiTaO₃ surface elastic wave substrate is connected to a wiring substrate through bumps, comprising the steps of,
arranging four or more bumps within an area of 0-1.0 mm x 0-1.0 mm from a chip center in said surface elastic wave chip with one side of at least 1-2 mm on said aluminum pads with a thickness of more than 3000 angstroms on a functional surface of said LiTaO₃ surface elastic wave substrate and,
heating said wiring substrate at a higher temperature than that of said surface elastic wave chip, to bond said surface elastic wave chip to said wiring substrate through said bumps.
